# FASCICULE DE BREVET EUROPEEN

(11) **EP 0 675 544 B1**
(45) Date de publication et mention de la délivrance du brevet: **19.05.1999**
(21) Numéro de dépôt: 95400710.0
(22) Date de dépôt: 30.03.1995
(51) Int. Cl.: H01L 29/423, H01L 21/336

(54) **Procédé de fabrication d'un transistor à effet de champ à grille isolée de longueur de canal réduite, et transistor correspondant**
Verfahren zur Herstellung eines Feldeffekttransistors mit isoliertem Gate und kurzem Kanal, und entsprechender Transistor
Method of manufacturing a short channel insulated field effect transistor; and corresponding transistor

(30) Priorité: 31.03.1994 FR 9403841
(43) Date de publication de la demande: 04.10.1995
(73) Titulaire: FRANCE TELECOM, 75015 Paris (FR)
(72) Inventeur: Straboni, Alain, F-38400 St. Martin d'Hère (FR); Mingam, Hervé, F-38920 Crolles (FR)
(74) Mandataire: Casalonga, Axel

(56) Documents cités:
- EP-A- 0 083 088
- EP-A- 0 495 541
- US-A- 4 597 827
- US-A- 5 061 647
- PATENT ABSTRACTS OF JAPAN vol. 009 no. 204 (E-337) ,21 Août 1985 & JP-A-60 066861 (TOSHIBA KK) 17 Avril 1985,
- INTERNATIONAL ELECTRON DEVICES MEETING 1986. TECHNICAL DIGEST (CAT. NO.86CH2381-2), LOS ANGELES, CA, USA, 7-10 DEC. 1986, 1986, NEW YORK, NY, USA, IEEE, USA, PAGE(S) 742 - 745, HUANG T ET AL 'A novel submicron LDD transistor with inverse-T gate structure'
- IBM TECHNICAL DISCLOSURE BULLETIN, vol. 33, no. 1A, Juin 1990 NEW YORK, US, pages 75-77, ANONYMOUS 'Low Series Resistance Source by Spacer Methods.'
- INTERNATIONAL ELECTRON DEVICES MEETING. TECHNICAL DIGEST, SAN FRANCISCO, CA, USA, 13-15 DEC. 1982, 1982, NEW YORK, NY, USA, IEEE, USA, PAGE(S) 718 - 721, OGURA S ET AL 'A half micron MOSFET using double implanted LDD'

## Description

L'invention concerne les transistors à effet de champ à grille isolée.

Les technologies courantes actuelles des transistors à effet de champ à grille isolée, plus communément appelés par l'homme du métier transistors "MOS", sont des technologies de 0,35 µm à 0,5 µm. Ces valeurs définissent en fait la longueur du canal du transistor à effet de champ, c'est-à-dire la distance séparant les régions de drain et de source.

On sait par ailleurs réaliser des transistor MOS présentant une longueur de canal très courte, de l'ordre du dixième de micron. Cependant, il est nécessaire d'utiliser des moyens photolithographiques très perfectionnés ou bien des masqueurs électroniques afin d'atteindre des finesses de trait avoisinant le dixième de micron. Une telle dimension constitue actuellement une butée technologique pour les techniques de fabrication les plus performantes.

Afin de franchir cette frontière technologique liée aux résolutions ultimes des masqueurs, des études ont été orientées vers l'emploi de rayons de longueur d'onde réduite, notamment des rayons X. Cependant, ces voies de recherche se sont heurtées à des problèmes liés à l'appareillage et aux réticules nécessaires pour mettre en oeuvre une telle technique.

Une autre solution consiste à réaliser une grille de transistor très courte, par les moyens technologiques actuels les plus performants, puis à graver de manière isotrope le film conducteur constituant cette grille ou le masque de résine protégeant ladite grille. Il a été ainsi possible de fabriquer un transistor présentant une longueur de canal de 40 nm.

Cependant, une telle solution est surtout intéressante sur le plan de la faisabilité car elle démontre qu'un transistor MOS ayant une longueur de canal de 0,04 µm continue de fonctionner normalement. Néanmoins, le procédé de surgravure utilisé présente l'inconvénient d'être très peu contrôlable d'un point à l'autre d'une plaquette de silicium et d'une plaquette à l'autre.

On peut également citer comme art antérieur JP-A-60 066 861; le bulletin technique d'IBM, vol. 33 n° 1A, Juin 1990, pages 75-77; EP-A-0083088, et l'article de OGURA, IEEE 1982 pages 718-721, qui décrivent la réalisation de transistors MOS à partir de structures étagées, ou encore l'article de HUANG, IEEE 1986 pages 742-745 qui décrit un transistor à grille en forme de T renversé symétrique.

L'un des buts de l'invention est de réaliser des transistors à effet de champ à grille isolée ayant des longueurs de canal réduites, typiquement de l'ordre de 0,1 µm voire moins, en utilisant des techniques classiques et habituellement utilisées pour la fabrication des transistors MOS courants notamment les transistors de la technologie 0,35/0,5 µm.

L'invention a également pour but de réaliser des transistors présentant une grille de taille réduite, continue, unique et intègre.

L'invention a encore pour but de réaliser des transistors permettant une meilleure maîtrise des phénomènes liés à la dégradation par porteurs chauds, et ce sans dégradation des performances des transistors.

Telle que revendiquée l'invention a pour objet un procédé de fabrication d'un transistor à effet de champ à grille isolée, comportant dans une zone prédéterminée d'un substrat semi-conducteur la formation de régions semi-conductrices de source et de drain et la formation, entre ces deux régions, d'une région de grille isolée. La formation de la région de grille comporte les étapes suivantes :
a) on forme, sur la surface supérieure d'une première couche semi-conductrice ou conductrice disposée sur une couche primaire isolante recouvrant ladite zone prédéterminée de substrat, une structure étagée comportant une couche superficielle semi-conductrice ou conductrice ayant une épaisseur choisie et formant une marche, et on forme, à l'endroit de ladite marche, à partir d'une gravure anisotrope de ladite couche superficielle, une région saillante comportant d'une part une partie centrale formée par la partie résiduelle non gravée de la couche superficielle, dont la largeur au pied, reliée à l'épaisseur de la couche superficielle, définit la longueur du canal du transistor, et d'autre part des régions latérales isolantes dissymétriques limitant ladite partie centrale,
b) on effectue une gravure anisotrope du bloc formé à l'étape a) de façon à graver partiellement la région saillante et à graver, sur la totalité de son épaisseur, la partie de la première couche semi-conductrice ou conductrice s'étendant de part et d'autre de ladite région saillante,
la région semi-conductrice ou conductrice de grille étant d'une part constituée d'une région centrale formée par la zone résiduelle non gravée de la partie centrale de la région saillante, et par la zone résiduelle non gravée de la première couche semi-conductrice ou conductrice définissant par rapport à ladite région centrale deux branches latérales dissymétriques, et étant d'autre part isolée du substrat par la partie de la couche primaire isolante située sous ladite zone résiduelle non gravée de la première couche semi-conductrice ou conductrice.

En d'autres termes, selon l'invention, la longueur du canal du transistor ainsi formé dépend directement de l'épaisseur de la couche superficielle. Or, les techniques classiques et couramment utilisées dans le domaine de la microélectronique, et en particulier dans le domaine de la fabrication des composants semi-conducteurs, permettent aisément, de façon contrôlable et reproductible, de déposer des épaisseurs de couches extrêmement faibles, pouvant aller jusqu'à des épaisseurs de l'ordre du dixième de micromètre voire moins. Aussi, puisque l'épaisseur des couches sur les parties verticales des marches est proportionnelle à l'épaisseur desdites couches sur les parties horizontales, l'invention permet donc, par l'utilisation de techniques simples et éprouvées, d'obtenir aisément des longueurs de canal de l'ordre du dixième de micron voire moins.

En outre, l'utilisation de la région saillante comme masque dans l'opération de gravure anisotrope effectuée à l'étape b), permet aisément de délimiter la largeur de la grille et ce, sans prévoir l'utilisation de résine et/ou de masque additionnel.

Dans un mode de mise en oeuvre de l'invention, la formation des régions semi-conductrices de drain et de source comporte avantageusement une première implantation de dopants effectuée après ia formation de la partie centrale semi-conductrice ou conductrice de la région saillante et avant la formation des régions latérales isolantes, et une deuxième implantation de dopants effectuée après l'étape b).

Selon un mode de mise en oeuvre du procédé selon l'invention, on effectue dans l'étape a) les sous-étapes suivantes :
a1) on dépose sur la face supérieure de la première couche semi-conductrice ou conductrice une couche additionnelle ayant une épaisseur choisie, et on effectue une gravure d'une zone prédéterminée de cette couche additionnelle, sur la totalité de son épaisseur, de façon à former un flanc pour la zone résiduelle non gravée de cette couche additionnelle et à découvrir la partie correspondante de la face supérieure de la première couche,
a2) on effectue, sur le bloc ainsi muni de ladite marche, et formé à l'étape a1), un dépôt conforme de la couche superficielle ayant une épaisseur choisie de façon à former ladite structure étagée,
a3) on effectue, une gravure anisotrope sélective de ladite couche superficielle sur la totalité de son épaisseur de façon à ne laisser subsister qu'une zone résiduelle de couche superficielle s'appuyant sur ledit flanc, et,
a4) on grave sélectivement la zone résiduelle de la couche additionnelle, sur la totalité de son épaisseur, de façon à ne laisser subsister sur la première couche semi-conductrice ou conductrice qu'une partie au moins de la zone résiduelle non gravée de la couche superficielle, qui forme ainsi ladite partie centrale de la région saillante.

Généralement, l'étape de formation de la région de grille du transistor s'effectue sur une zone prédéterminée de substrat limitée par une zone d'isolement électrique. Dans ce cas, dans l'étape a1), on peut former par la gravure partielle de la couche additionnelle un autre flanc pour la zone résiduelle non gravée de cette couche additionnelle, cet autre flanc étant alors situé sur ladite zone d'isolement. Ceci permet de préserver l'unicité de la région semi-conductrice ou conductrice de grille du transistor. En effet, une autre zone résiduelle non gravée de couche superficielle se forme lors de la gravure anisotrope de cette couche superficielle. Si cette autre zone résiduelle n'était pas formée sur une zone d'isolement électrique, elle formerait avec la première zone résiduelle non gravée de couche superficielle une grille double pour le transistor.

Dans le cas où l'on souhaite obtenir par le procédé selon l'invention, un transistor présentant une région semi-conductrice ou conductrice de grille constituée non seulement par la zone résiduelle non gravée de la première couche semi-conductrice ou conductrice mais également par une zone résiduelle non gravée semi-conductrice ou conductrice de la région saillante, on choisit avantageusement la hauteur de la partie de la zone résiduelle de couche superficielle subsistant après l'étape a4, supérieure à l'épaisseur de ladite première couche. Généralement, cette hauteur correspond sensiblement à l'épaisseur de la couche additionnelle. Cette couche additionnelle est constituée d'un matériau présentant une sélectivité de gravure importante par rapport au matériau constituant la couche superficielle et la première couche semi-conductrice ou conductrice. Le matériau de la couche additionnelle peut être ainsi soit isolant soit semi-conducteur. On utilisera de préférence, notamment pour l'obtention aisée d'une sélectivité de gravure, un matériau isolant.

L'utilisation de la couche additionnelle présente en outre un autre avantage. En effet, il est particulièrement avantageux, pour la formation des régions de drain et de source, d'effectuer entre l'étape a3) et l'étape a4), c'est-à-dire avant retrait de la couche additionnelle, une implantation de dopants. La couche additionnelle permettra alors de piéger les dopants dans celle-ci et de ne doper que la région de substrat située à l'opposé de cette couche additionnelle, par rapport à la région saillante. On obtiendra ainsi un dopage final différent pour les régions de source et de drain.

Telle que revendiquée, l'invention a également pour objet un transistor à effet de champ à grille isolée dont la région semi-conductrice ou conductrice de grille comporte une partie centrale semi-conductrice ou conductrice disposée sur une partie inférieure semi-conductrice ou conductrice, isolée du substrat par une couche isolante, ainsi que des régions latérales isolantes s'appuyant sur la partie centrale semi-conductrice ou conductrice et sur la face supérieure de la partie inférieure semi-conductrice ou conductrice de la grille. Selon l'invention, la partie inférieure de la région de grille définit par rapport à la partie centrale deux branches latérales dissymétriques. En d'autres termes, on obtient ici une structure de transistor à effet de champ dont la région semi-conductrice ou conductrice de grille présente une configuration sensiblement en forme de T renversé dissymétrique. En outre, l'une des régions de drain et de source peut être avantageusement plus fortement dopée que l'autre. Par ailleurs, les deux branches latérales de la partie inférieure semi-conductrice ou conductrice de grille recouvrent avantageusement partiellement respectivement les régions de drain et de source. Il est à cet effet préférable que ce soit la région de drain qui soit plus faiblement dopée que la région de source et que cette région de drain soit en outre partiellement recouverte par la branche la plus longue de la partie inférieure semi-conductrice de grille.

L'invention permet ainsi d'obtenir des transistors à effet de champ permettant une meilleure maîtrise des phénomènes liés à la dégradation par porteur chaud. Cette meilleure tenue au vieillissement peut également se combiner avec l'obtention d'une résistance série minimum du côté de la source et un dopage non uniforme efficace du côté du drain.

D'autres avantages et caractéristiques de l'invention apparaîtront à l'examen de la description détaillée de modes de mise en oeuvre et de réalisation de l'invention, nullement limitatifs, et des dessins annexés sur lesquels :
- les figures 1a à 1h illustrent un premier mode de mise en oeuvre d'un procédé de fabrication permettant l'obtention d'un transistor de longueur de canal réduite, et ne comportant pas toutes les caractéristiques de l'invention revendiquée,
- les figures 2a à 2c illustrent une variante de mise en oeuvre du procédé illustré sur les figures 1a à 1h,
- les figures 3a à 3c illustrent un mode de mise en oeuvre du procédé selon l'invention et une première structure d'un transistor dissymétrique selon l'invention, et,
- les figures 4a à 4c illustrent une variante de mise en oeuvre du procédé selon l'invention et une autre variante de réalisation d'un transistor dissymétrique selon l'invention.

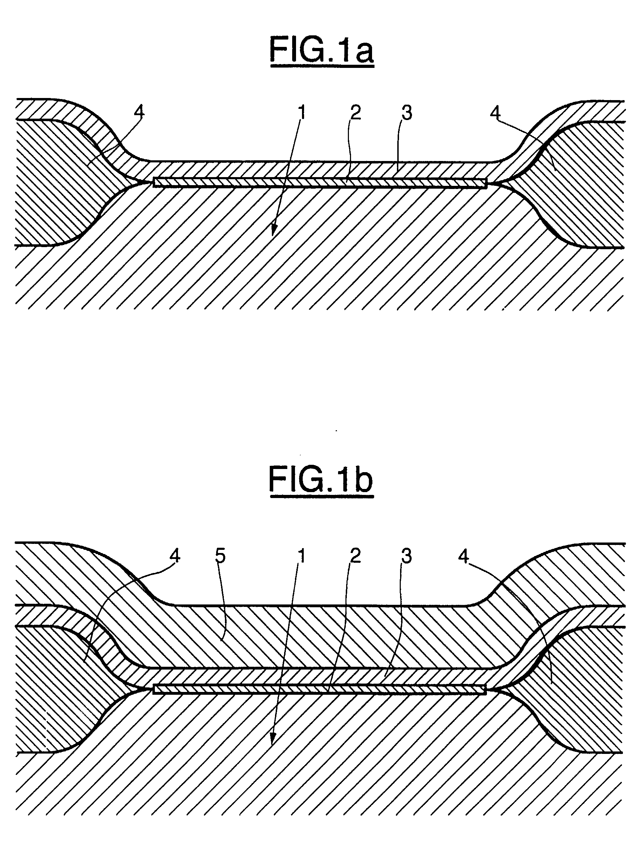

On se réfère maintenant en détail aux figures 1a à 1h.

On réalise au sein d'un substrat semi-conducteur, par exemple un substrat de silicium ou un substrat sur isolant (SOI "Silicon On Insulator") une zone d'isolement électrique formée ici de deux zones d'isolement latérales 4. Ces zones d'isolement latérales peuvent être être réalisées de façon classique en utilisant une technique d'oxydation localisée plus communément appelée par l'homme du métier "LOCOS". Ces zones d'isolement peuvent être également des tranchées latérales peu profondes réalisables par le technique connue par l'homme du métier sous le vocable "Box" ou "STI (Shallow Trench Isolation)".

On définit ainsi entre ces régions latérales d'isolement 4 une zone prédéterminée de substrat 1 que l'on implante avantageusement pour former par exemple des caissons ou effectuer des ajustement de seuil.

On fait ensuite croître sur la face supérieure du substrat une couche primaire isolante 2 qui réalisera ultérieurement l'oxyde de grille du transistor. Cette couche isolante est par exemple formée de dioxyde de silicium et a une épaisseur typiquement inférieure ou égale à 10 manomètres.

On dépose sur cette couche primaire isolante une première couche semi-conductrice 3, par exemple formée de polysilicium, et ayant une épaisseur généralement comprise entre 20 et 200 manomètres. Cette première couche 3 peut être également conductrice, par exemple métallique et en particulier constituée de chrome. Dans la suite du texte, on supposera que la couche 3 est semi-conductrice.

On dépose ensuite (figure 1b), sur le bloc semi-conducteur ainsi formé, une couche additionnelle épaisse 5, de préférence une couche isolante, ayant une épaisseur typiquement comprise entre 100 et 500 manomètres.

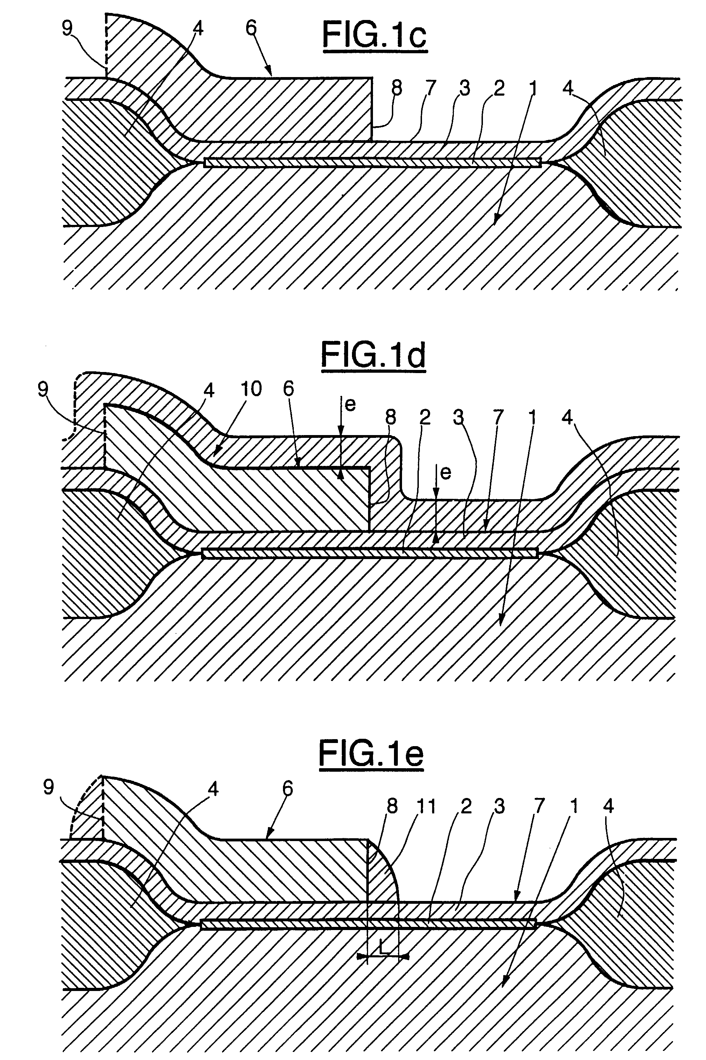

L'étape suivante, illustrée sur la figure 1c, consiste à effectuer une gravure anisotrope de la couche épaisse 5, avec arrêt sur la première couche semi-conductrice 3 de façon à former un flanc 8 pour la zone résiduelle non gravée 6 de cette couche additionnelle 5 et à découvrir la partie correspondante 7 de la face supérieure de la première couche semi-conductrice 3.

Cette gravure anisotrope a été effectuée postérieurement à un dépôt classique de résine et à une étape de photolithographie classique permettant la définition de la zone à graver.

La définition du masque utilisé pour l'étape de photolithographie conduit généralement à la formation lors de la gravure anisotrope d'un autre flanc 9 pour la zone résiduelle non gravée 6 de la couche additionnelle 5. Il convient alors que cet autre flanc 9 soit situé sur l'une des régions d'isolement électrique 4 afin, comme on le verra plus en détail ci-après, de conserver une unicité de grille pour le transistor finalement formé.

On effectue ensuite (figure 1d) un dépôt conforme d'une couche superficielle 10 ayant une épaisseur choisie e. Cette couche superficielle est ici avantageusement semi-conductrice, et de préférence constituée du même matériau que celui formant la première couche semi-conductrice 3 (silicium polycristallin par exemple). Cette couche superficielle pourrait également être conductrice (tungstène par exemple).

Le bloc semi-conducteur ainsi formé comporte donc sur la première couche semi-conductrice 3 une structure étagée dans laquelle la couche superficielle 10 forme une marche au niveau du flanc 8 de la couche additionnelle 6.

Un dépôt conforme est, selon une dénomination couramment utilisée par l'homme du métier, un dépôt conduisant à l'obtention d'une couche dont l'épaisseur e à la tête de marche est sensiblement identique à l'épaisseur e au pied de cette marche. En d'autres termes, un dépôt conforme d'une couche permet à celle-ci de bien épouser les reliefs de la structure sur laquelle elle est déposée. On pourra utiliser comme dépôt conforme, un dépôt dit "CVD" (CHEMICAL VAPOR DEPOSITION).

On procède ensuite (figure 1e) à une gravure anisotrope sélective de la couche superficielle 10, sur la totalité de son épaisseur, (avec arrêt sur la première couche 3 et sur la couche additionnelle 6) de façon à ne laisser subsister qu'une zone résiduelle 11 de couche superficielle s'appuyant sur le flanc 8. En fait, une autre zone résiduelle, représentée en tireté sur la figure 1e, et s'appuyant sur le flanc 9, subsiste après la gravure. Néanmoins, la position de cette autre zone superficielle sur la zone d'isolement latérale 4 la rend inactive vis-à-vis du transistor ce qui garantit l'unicité de la grille de celui-ci.

La gravure est anisotrope c'est-à-dire qu'elle est effectuée uniquement dans une seule direction, ici la direction verticale. La largeur L au pied de la zone résiduelle 11 de la couche superficielle est directement liée à l'épaisseur e de la couche superficielle. Plus précisément cette largeur L est égale à α.e ou α est de l'ordre 0,8 à 1. Aussi, puisque les méthodes classiques de dépôt conforme notamment permettent de déposer des couches d'épaisseur très réduite, il en résulte une largeur L également très réduite. En pratique, on choisira pour obtenir des longueurs L de canal de l'ordre de 0,1 µm, une épaisseur e de couche superficielle de l'ordre de 1000 à 1200 Å.

Bien entendu, il est possible avec le procédé selon l'invention, de réduire encore davantage la longueur L souhaitée en ajustant l'épaisseur de la couche superficielle. La sélectivité de la gravure s'obtient en choisissant des matériaux respectifs pour la couche superficielle la couche additionnelle présentant des rapports de vitesse de gravure de l'ordre de 10 voire plus, compte tenu des caractéristiques chimiques de la gravure utilisée.

Avant d'effectuer la gravure anisotrope de la couche superficielle 10, on pourra avantageusement délimiter à l'aide d'un petit bloc de résine l'emplacement ultérieur du contact de grille. Cet emplacement ultérieur est décalé latéralement par rapport au plan de la figure 1d. On obtient alors, après gravure, un emplacement de contact de surface suffisante par rapport à la surface supérieure de la future grille du transistor.

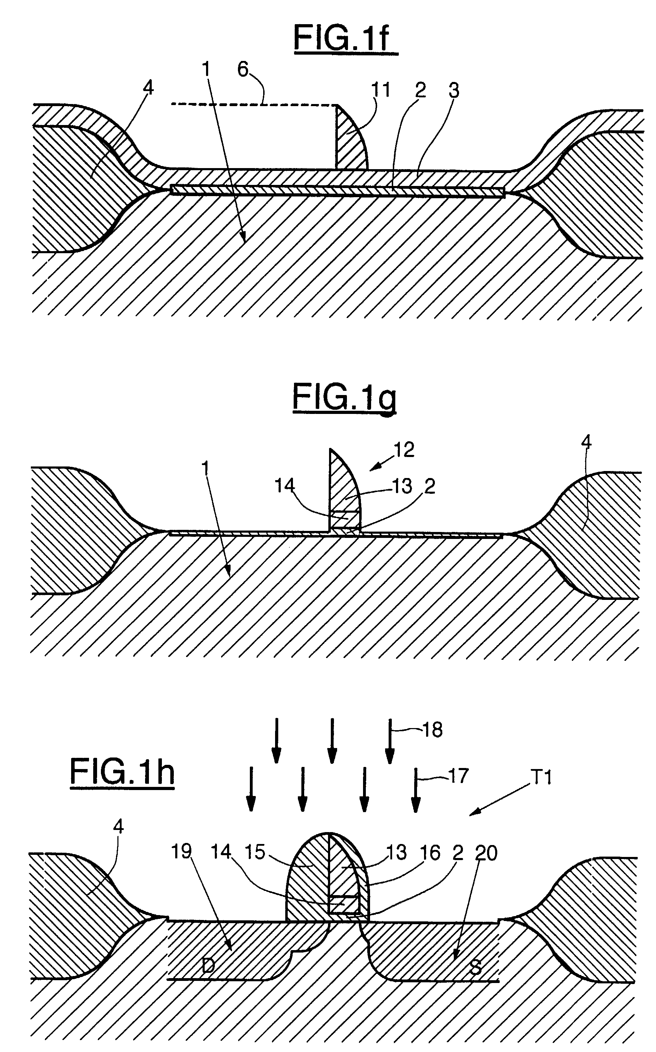

On effectue (figure 1f) une gravure sélective anisotrope de la zone résiduelle 6 de la couche additionnelle de façon à ne laisser subsister sur la première couche semi-conductrice 3 que la zone résiduelle 11 non gravée de la couche superficielle, ou tout au moins la majeure partie, car, bien que la gravure soit effectuée de façon sélective, une partie minime de cette zone résiduelle de couche superficielle peut être également gravée simultanément à la gravure de la couche additionnelle. La gravure de cette couche additionnelle 6 est sélective par rapport à la couche superficielle mais également par rapport à la première couche semi-conductrice 3. En pratique, on choisira des matériaux respectifs présentant des rapports de vitesse de gravure de l'ordre de 10 compte tenu des caractéristiques chimiques de la gravure utilisée. En pratique, une couche additionnelle formée d'oxyde de silicium ainsi que des couches superficielles formées de polysilicium conviendront.

On obtient donc à ce stade du procédé, une partie saillante 11, illustrée sur la figure 1f, et ne comportant qu'une seule partie centrale. On procède ensuite (figure 1g) à une gravure anisotrope du bloc semi-conducteur de la figure 1f, de façon à graver, sur la totalité de son épaisseur, la partie de la première couche semi-conductrice 3 s'étendant de part et d'autre de la région saillante.

Lors de cette opération de gravure, la zone résiduelle 11 de couche superficielle est également gravée. Aussi, il est possible qu'elle disparaisse complètement pour ne laisser subsister alors qu'une zone résiduelle non gravée 14 de première couche semi-conductrice. C'est notamment le cas lorsque la hauteur de la zone résiduelle non gravée 11 de la couche superficielle, qui correspond en fait sensiblement à l'épaisseur de la couche additionnelle isolante 6, est égale voire inférieure à l'épaisseur de la première couche semi-conductrice. Cependant, généralement, on choisira une hauteur de zone résiduelle non gravée de couche superficielle 11, c'est-à-dire une épaisseur de couche additionnelle isolante, supérieure à l'épaisseur de la première couche semi-conductrice. Bien sûr, dans ce cas, il est nécessaire de choisir une couche superficielle également semi-conductrice ou conductrice. De ce fait, comme illustré sur la figure 1g, on obtiendra alors après l'opération de gravure anisotrope, une région semi-conductrice de grille 12 composée en partie inférieure de la zone résiduelle non gravée 14 de la première couche semi-conductrice et surmontée d'une partie au moins 13 de ia zone résiduelle non gravée de couche superficielle. La longueur de la grille est alors égale à la longueur de canal.

Cette gravure anisotrope est sélective par rapport à la couche primaire isolante 2 et par rapport aux régions d'isolement 4. Après gravure, il subsiste une fine pellicule résiduelle de couche primaire isolante, de part et d'autre de la région semi-conductrice de grille. On procède ensuite avantageusement (figure 1h) à une première implantation de dopants 17 au travers de la pellicule résiduelle d'oxyde. On effectue ensuite sur la surface du substrat semi-conducteur et sur la région semi-conductrice de grille, un dépôt d'une couche isolante épaisse (non représentée ici à des fins de simplification) puis à une gravure anisotrope de celle-ci de façon à former des régions latérales isolantes ou espaceurs 15 et 16. A cet effet, on remarquera ici que les espaceurs sont dissymétriques en raison de la configuration de la région semi-conductrice de grille présentant un flanc abrupt d'un côté et arrondi de l'autre côté. On procède ensuite à une deuxième implantation de dopants 18 de façon à former des régions actives 19 et 20 présentant des dopages non uniformes connus par l'homme du métier sous le vocable "LDD". La zone de drain D sera alors avantageusement choisie comme étant celle située partiellement sous l'espaceur 15 le plus large.

Les dernières étapes de fabrication du transistor T1 ainsi obtenu consistent en des prises de contact métallique sur les régions de drain et de source ainsi que sur la zone de contact de grille préalablement aménagée. Ces prises de contact sont tout à fait classiques.

Le transistor T1 est donc un transistor à effet de champ de grille isolée présentant une longueur de grille et de canal réduite, typiquement de l'ordre de 0,1 µm. Il a été obtenu aisément par des techniques classiquement utilisées pour la technologie courante 0,35/0,5 µm par exemple.

En outre la dissymétrie des dopages non uniformes entre les régions de drain 19 et de source 20 permet de réduire avantageusement la résistance série du côté source.

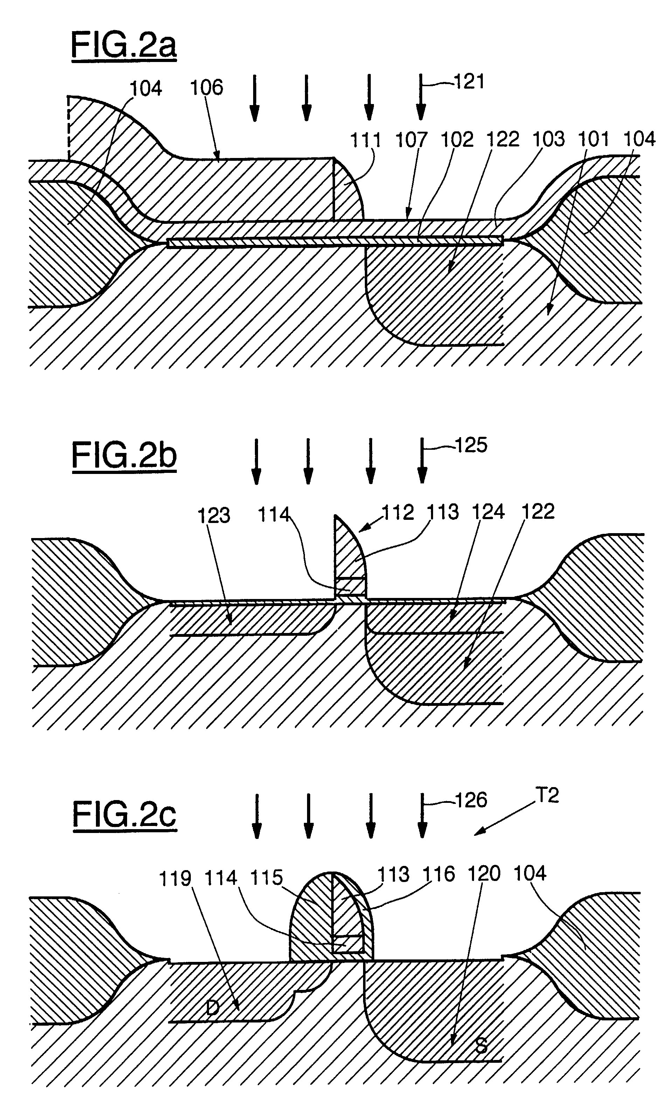

Les figures 2a à 2c illustrent une variante de mise en oeuvre du procédé qui vient d'être décrit. Sur ces figures, les éléments analogues ou ayant des fonctions analogues à ceux représentés sur l'ensemble des figures 1a à 1h ont des références augmentées de 100 par rapport à celles qu'ils avaient sur les figures 1a à 1h. Seules les différences entre l'ensemble de ces figures seront maintenant décrites.

La figure 2a est analogue à la figure 1e. Néanmoins, à ce stade du procédé, on procède avantageusement à une implantation primaire 121 de dopants conduisant à la réalisation d'une zone dopée 122 située sous la partie découverte 107 de la première couche semi-conductrice. La présence de la couche additionnelle 106 permet de piéger les dopants à l'intérieur de celle-ci et évite une implantation du substrat.

Après réalisation de la région saillante et gravure de la première couche semi-conductrice de part et d'autre de cette région saillante, de façon à obtenir la région semi-conductrice de grille 112, on procède à une deuxième implantation de dopants 125, de plus faible énergie que celle de l'implantation 121, conduisant d'une part à la réalisation d'une zone de substrat dopé 124 située au même endroit que la zone dopée 122 mais moins profondément dopée que cette zone 122, et, d'autre part à la réalisation d'une autre zone dopée 123 située dans le substrat de l'autre côté de la région de grille 112. Cette zone 123 est moins profondément dopée que la zone 124. De ce fait, comme illustré sur la figure 2c, après formation des espaceurs isolants 115 et 116, et une nouvelle implantation 126, à travers la pellicule résiduelle d'oxyde (non représentée à des fins de simplification), on obtient une zone active 119 moins profondément dopée que la zone active homologue 120. L'énergie d'implantation 126 est comprise entre celle des implantations 125 et 121.

Ainsi, outre le fait que ce transistor T2 présente également une longueur de canal et de grille réduite, ainsi qu'une dissymétrie entre drain et source, (si l'on choisit d'utiliser la région 119 en tant que région de drain et la région 120 en tant que région de source) le dopage profond et plus fort côté source (la région 120 a été implantée trois fois) contribue encore à minimiser la résistance série du côté source tandis que le dopage non uniforme du drain (LDD) est plus long, donc plus efficace pour une meilleure résistance au vieillissement par porteurs chauds.

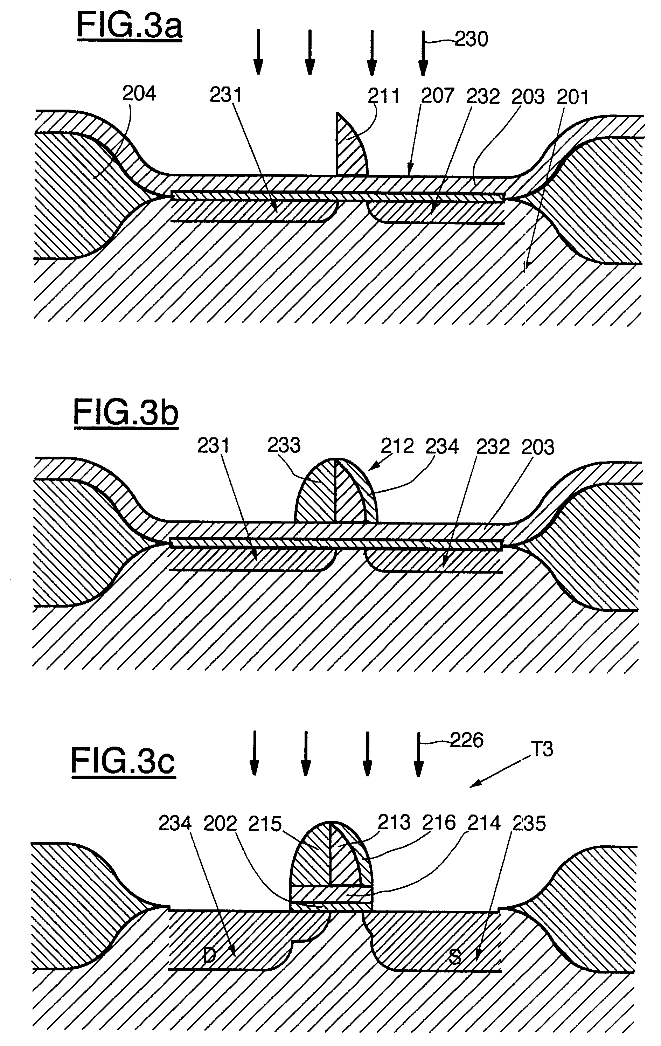

Les figures 3a à 3c illustrent un mode de mise en oeuvre du procédé selon l'invention. Sur ces figures, les éléments analogues ou ayant des fonctions analogues à ceux illustrés sur les figures 1a à 1h ont des références augmentées de 200 par rapport à celles qu'ils avaient sur ces figures. Seules les différences entre ces deux groupes de figures seront maintenant décrites.

Cette variante de l'invention permet d'obtenir un transistor ayant une région de grille sensiblement en forme d'un T renversé dissymétrique.

Comme illustré sur la figure 3a, après gravure sélective de la couche résiduelle non gravée de la couche additionnelle, permettant d'obtenir la partie centrale semi-conductrice 211 de la région saillante, on procède sur la structure semi-conductrice ainsi obtenue à une implantation de dopants 230 permettant d'obtenir dans le substrat de part et d'autre de la partie centrale 211 de la région saillante deux régions dopées 231 et 232.

On procède ensuite (figure 3b) au dépôt sur la structure semi-conductrice de la figure 3a d'une couche isolante épaisse (non représentée ici à des fins de simplification) puis à une gravure anisotrope de celle-ci pour former d'une façon analogue à celle qui a été exposée ci-avant, deux espaceurs dissymétriques 233 et 234. Ces deux espaceurs s'appuient d'une part sur la partie centrale semi-conductrice 211 et d'autre part sur la face supérieure de la première couche semi-conductrice 203. La région saillante 212 est donc formée ici par la partie centrale semi-conductrice 211 et par les deux espaceurs isolants 233 et 234.

On procède alors (figure 3c) à la gravure anisotrope de la structure ainsi formée de façon à graver la première couche semi-conductrice 203 de part et d'autre de la région saillante 212. On obtient finalement une région semi-conductrice de grille composée d'une partie centrale semi-conductrice 213 disposée sur une partie inférieure semi-conductrice 214 définissant par rapport à cette partie centrale deux branches latérales dissymétriques. Ces deux branches latérales sont dites dissymétriques car elles sont d'inégale longueur. La région semi-conductrice de grille est isolée du substrat par la portion de couche isolante 202 située sous la partie inférieure semi-conductrice 214. Les espaceurs 215 et 216 s'appuient sur la partie centrale 213 de la région de grille et sur la face supérieure de la partie inférieure 214.

On procède alors à une implantation de dopants 226 permettant d'obtenir les dopages source et drain pour les deux régions actives 234 et 235.

Là encore, si l'on choisit comme région de drain la région 234 et comme région de source la région 235, on obtient outre les avantages exposés ci-avant, un recouvrement partiel de la région de drain par la région de grille ce qui permet de drainer les porteurs chauds dans la région de grille en évitant une injection de ceux-ci dans les espaceurs isolants, ce qui est favorable à la résistance au vieillissement du transistor T3.

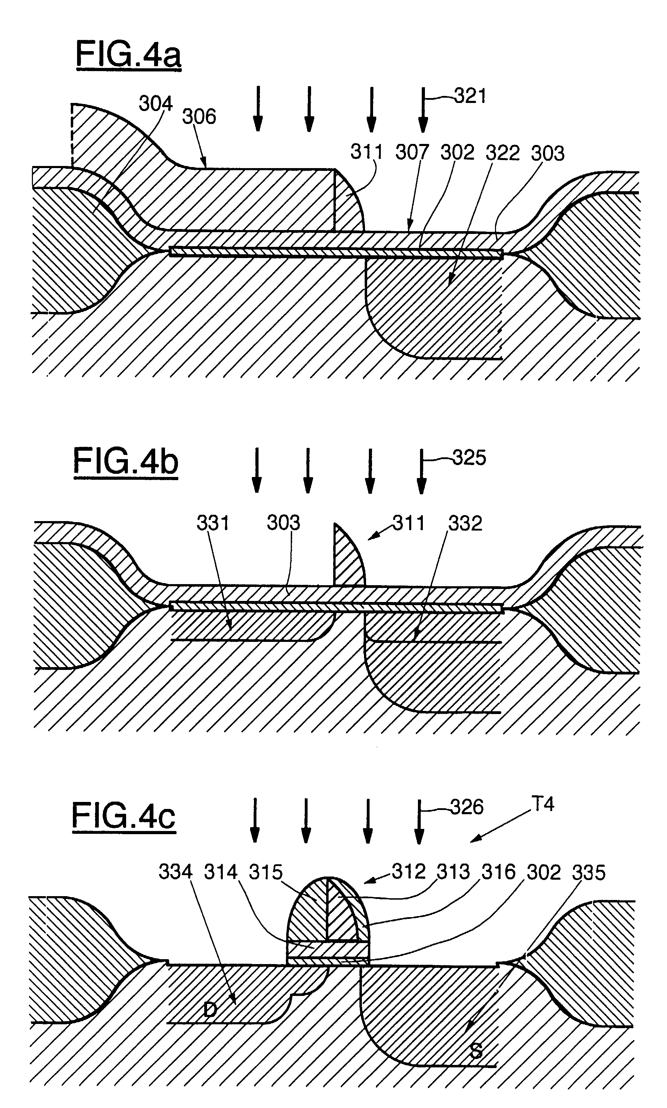

Par rapport à la variante de mise en oeuvre illustrée sur les figures 3a à 3c, celle illustrée sur les figures 4a à 4c se distingue par le fait que préalablement à la gravure sélective de la zone résiduelle 306 de couche additionnelle, on effectue une implantation supplémentaire de dopants 321 de façon à définir d'une façon analogue à celle illustrée sur la figure 2a une zone de substrat dopée 322. Puis, comme illustré sur la figure 4b, avant formation des espaceurs isolants de la région de la saillante, on effectue une autre implantation 325 de façon à obtenir les zones de substrat dopées 331 et 332. On obtient finalement sur la figure 4c, après une gravure de part et d'autre de la région saillante 312 et implantation 326, un transistor T4 ayant une structure sensiblement analogue à celle du transistor T3 mais présentant une zone active de substrat 335, de préférence la zone de source, plus profondément et plus fortement dopée que la région homologue 334, de préférence de drain, ce qui permet de minimiser là encore la résistance série du côté source et d'obtenir un dopage non uniforme plus efficace du côté du drain.

## Revendications

1. Procédé de fabrication d'un transistor à effet de champ à grille isolée, comportant dans une zone prédéterminée d'un substrat semi-conducteur (201, 301) la formation de régions semi-conductrices de source et de drain et la formation, entre ces deux régions, d'une région de grille isolée, la formation de la région de grille comportant les étapes suivantes :
a) on forme, sur la surface supérieure d'une première couche semi-conductrice ou conductrice (203, 303) disposée sur une couche primaire isolante (202, 302) recouvrant ladite zone prédéterminée de substrat (201, 301), une structure étagée comportant une couche superficielle (10) semi-conductrice ou conductrice ayant une épaisseur choisie (e) et formant une marche, et on forme, à l'endroit de ladite marche, à partir d'une gravure anisotrope de ladite couche superficielle, une région saillante (212; 312) comportant d'une part une partie centrale (211; 311) formée par la partie résiduelle non gravée de la couche superficielle, dont la largeur au pied (L), reliée à l'épaisseur (e) de la couche superficielle (10), définit la longueur du canal du transistor, et d'autre part des régions latérales isolantes dissymétriques (233, 334) limitant ladite partie centrale,
b) on effectue une gravure anisotrope du bloc formé à l'étape a) de façon à graver partiellement la région saillante et à graver, sur la totalité de son épaisseur, la partie de la première couche semi-conductrice ou conductrice (203, 303) s'étendant de part et d'autre de ladite région saillante,
la région semi-conductrice ou conductrice de grille étant d'une part constituée d'une région centrale formée par la zone résiduelle non gravée de la partie centrale de la région saillante, et par la zone résiduelle non gravée (214, 314) de la première couche semi-conductrice ou conductrice définissant par rapport à ladite région centrale deux branches latérales dissymétriques, et étant d'autre part isolée du substrat par la partie de la couche primaire isolante située sous ladite zone résiduelle non gravée (214, 314) de la première couchc semi-conductrice ou conductrice (203, 303).

2. Procédé selon la revendication 1, caractérisé par le fait que la formation des régions semi-conductrices de drain et de source comporte une première implantation de dopants effectuée après la formation de la partie centrale de la région saillante et avant la formation des régions latérales isolantes, et une deuxième implantation de dopants effectuée après l'étape b).

3. Procédé selon la revendication 1 ou 2, caractérisé par le fait que la largeur au pied de la partie centrale de la région saillante est de l'ordre de 10² nm (1000 Å).

4. Procédé, selon l'une des revendications 1 à 3, caractérisé par le fait que dans l'étape a):
a1) on dépose sur la face supérieure de ladite première couche (203, 303) une couche additionnelle (5) ayant une épaisseur choisie, et on effectue une gravure d'une zone prédéterminée de cette couche additionnelle, sur la totalité de son épaisseur, de façon à former un flanc (8) pour la zone résiduelle non gravée (6) de cette couche additionnelle (5) et à découvrir la partie correspondante (7) de la face supérieure de ladite première couche,
a2) on effectue, sur le bloc formé à l'étape a1), un dépôt conforme de la couche superficielle (10) ayant une épaisseur choisie de façon à former ladite structure étagée,
a3) on effectue, une gravure anisotrope de ladite couche superficielle (10) sur la totalité de son épaisseur de façon à ne laisser subsister qu'une zone résiduelle (211, 311) de couche superficielle s'appuyant sur ledit flanc (8), et,
a4) on grave sélectivement la zone résiduelle (6) de la couche additionnelle, sur la totalité de son épaisseur, de façon à ne laisser subsister sur ladite première couche qu'une partie au moins de la zone résiduelle non gravée de la couche superficielle pour former la partie centrale de la région saillante.

5. Procédé selon la revendication 4, caractérisé par le fait que la formation des régions latérales isolantes dissymétriques (233, 234) limitant la partie centrale (211) de la région saillante comporte le dépôt d'une couche isolante sur le bloc formé à l'étape a4) puis une gravure anisotrope de cette couche isolante.

6. Procédé selon la revendication 4 ou 5, caractérisé par le fait que ladite zone prédéterminée de substrat (201, 301) est limitée par une zone d'isolement électrique (204, 304), et par le fait que dans l'étape a1) on forme par la gravure partielle de la couche additionnelle, un autre flanc pour la zone résiduelle non gravée (6) de cette couche additionnelle, cet autre flanc étant situé sur ladite zone d'isolement (204, 304).

7. Procédé selon la revendication 4, 5 ou 6, caractérisé par le fait que la hauteur de la partie de la zone résiduelle de couche superficielle subsistant après l'étape a4) est supérieure à l'épaisseur de la première couche semi-conductrice ou conductrice (203, 303), et par le fait que la partie de la zone résiduelle de couche superficielle subsistant après l'étape a4) forme ladite partie centrale de la région saillante.

8. Procédé selon l'une des revendications 4 à 7, caractérisé par le fait que la couche additionnelle est une couche isolante.

9. Procédé selon la revendication 7 ou 8 prise en combinaison avec la revendication 2, caractérisé par le fait que la formation des régions de drain et de source comporte une implantation supplémentaire de dopants effectuée entre l'étape a3) et l'étape a4).

10. Procédé selon l'une des revendications précédentes, caractérisé par le fait que l'on choisit des matériaux identiques pour la première couche et la couche superficielle.

11. Transistor à effet de champ à grille isolée, comprenant une région de grille comportant une partie centrale semi-conductrice ou conductrice (213) disposée sur une partie inférieure semi-conductrice ou conductrice (214), isolée du substrat par une couche isolante (202), ainsi que des régions latérales isolantes (215,216) s'appuyant sur la partie centrale et sur la face supérieure de la partie inférieure, caractérisé par le fait que la partie inférieure (214) de la région de grille définit par rapport à la partie centrale (213) deux branches latérales dissymétriques.

12. Transistor selon la revendication 11, caractérisé par le fait que l'une des régions de drain (334) et de source (335) est plus fortement dopée que l'autre.

13. Transistor selon la revendication 11 ou 12, caractérisé par le fait que les branches latérales de la partie inférieure de grille (214) recouvrent partiellement respectivement les régions de drain (234) et de source (235).

14. Transistor selon les revendication 12 et 13, caractérisé par le fait que la région de drain, plus faiblement dopée que la région de source, est partiellement recouverte par la branche la plus longue de la partie inférieure de grille (214).

## Patentansprüche

1. Verfahren zur Herstellung eines Feldeffekttransistors mit isolierter Steuerelektrode, bei dem in einem bestimmten Bereich eines Halbleitersubstrats (201, 301) halbleitende Source- und Drain-Zonen sowie zwischen diesen beiden Zonen ein isolierter Steuerelektrodenbereich gebildet wird, wobei die Bildung des Steuerelektrodenbereichs in folgenden Schritten erfolgt:
a) auf der Oberfläche einer ersten halbleitenden oder leitenden Schicht (203, 303), die auf einer Primärsperrschicht (202, 302) auf dem besagten Substratbereich (201, 301) liegt, wird ein gestufter Aufbau mit einer halbleitenden oder leitenden Oberflächenschicht (10) einer ausgewählten Stärke (e) angelegt, die stufenförmig ausgebildet ist, und auf dieser Stufe wird mit Hilfe einer anisotropen Ätzung auf dieser Oberflächenschicht ein reliefartig hervorspringender Bereich (212, 312) gebildet, der einerseits aus einem Mittelteil (211, 311) aus dem nicht ausgeätzten Rest der Oberflächenschicht besteht, dessen Basisbreite (L) in Verbindung mit der Stärke (e) der Oberflächenschicht (10) die Länge des Transistorkanals bestimmt, sowie andererseits aus unsymmetrischen seitlichen Sperrbereichen (233, 334), die diesen Mittelteil begrenzen;
b) auf dem in Schritt a) gebildeten Block wird mit Hilfe einer anisotropen Ätzung teilweise der reliefartig hervorspringende Bereich ausgeätzt und der Teil der ersten halbleitenden oder leitenden Schicht (203, 303) beiderseits des reliefartig hervorspringenden Bereichs auf seiner gesamten Breite ausgeätzt,
wobei der halbleitende oder leitende Bereich der Steuerelektrode einerseits aus einem Mittelteil besteht, der aus dem nicht ausgeätzten restlichen Mittelteil des reliefartig hervorspringenden Bereichs und aus dem nicht ausgeätzten Rest (214, 314) der ersten halbleitenden oder leitenden Schicht gebildet wird, die zum besagten Mittelbereich zwei unsymmetrische seitliche Schenkel bilden, und andererseits vom Substrat durch den unter dem nicht ausgeätzten Rest (214, 314) der ersten halbleitenden oder leitenden Schicht (203, 303) liegenden Teil der Primärsperrschicht isoliert ist.

2. Verfahren nach Patentanspruch 1, dadurch gekennzeichnet, daß für die Bildung der halbleitenden Drain- und Source-Zonen Dotiermittel zum ersten Mal nach der Bildung des Mittelteils des reliefartig hervorspringenden Bereichs und vor der Bildung der seitlichen Sperrbereiche und zum zweiten Mal nach Schritt b) zugesetzt werden.

3. Verfahren nach Patentanspruch 1 oder 2, dadurch gekennzeichnet, daß die Basisbreite des Mittelteils des reliefartig hervorspringenden Bereichs etwa 10² nm (1000 Å) beträgt.

4. Verfahren nach einem der Patentansprüche 1 bis 3, dadurch gekennzeichnet, daß in Schritt a):
a1) auf der Oberfläche der besagten ersten Schicht (203, 303) eine Zusatzschicht (5) mit einer ausgewählten Stärke aufgebracht wird, und ein bestimmter Bereich aus dieser Zusatzschicht auf seiner gesamten Stärke ausgeätzt wird, so daß eine Seitenfläche (8) für den nicht ausgeätzten Restbereich (6) dieser Zusatzschicht (5) entsteht und der entsprechende Teil (7) der Oberfläche der besagten ersten Schicht freigelegt wird,
a2) auf dem in Schritt al) hergestellten Block ein der Oberflächenschicht (10) entsprechender Niederschlag mit einer ausgewählten Stärke aufgebracht wird, so daß der besagte stufige Aufbau entsteht,
a3) auf der besagten Oberflächenschicht (10) eine anisotrope Ätzung auf der gesamten Stärke durchgeführt wird, so daß nur ein Restbereich (211, 311) der Oberflächenschicht stehenbleibt, der die besagte Seitenfläche (8) stützt, und
a4) der Restbereich (6) der Zusatzschicht gezielt auf seiner gesamten Breite ausgeätzt wird, so daß auf der besagten ersten Schicht nur ein Teil zumindest des nicht ausgeätzten Restes der Oberflächenschicht stehenbleibt, der den Mittelteil des reliefartig hervorspringenden Bereichs bildet.

5. Verfahren nach Patentanspruch 4, dadurch gekennzeichnet, daß für die Bildung der unsymmetrischen seitlichen Sperrbereiche (233, 234), die den Mittelteil (211) des reliefartig hervorspringenden Bereichs begrenzen, auf dem in Schritt a4) hergestellten Block eine Sperrschicht aufgetragen wird und diese Sperrschicht anschließend mit einer anisotropen Ätzung bearbeitet wird.

6. Verfahren nach Patentanspruch 4 oder 5, dadurch gekennzeichnet, daß der bestimmte Substratbereich (201, 301) durch einen elektrischen Sperrbereich (204, 304) begrenzt wird und daß in Schritt al) durch teilweise Ätzung der Zusatzschicht eine weitere Seitenfläche für den nicht geätzten Restbereich (6) dieser Zusatzschicht gebildet wird, die auf dem besagten Sperrbereich (204, 304) liegt.

7. Verfahren nach Patentanspruch 4, 5 oder 6, dadurch gekennzeichnet, daß die Höhe des nach Schritt a4) noch stehengebliebenen Restbereichs der Oberflächenschicht größer als die Stärke der ersten halbleitenden oder leitenden Schicht (203, 303) ist und daß der nach Schritt a4) noch stehengebliebene Restbereich der Oberflächenschicht den besagten Mittelteil des reliefartig hervorspringenden Bereichs bildet.

8. Verfahren nach einem der Patentansprüche 4 bis 7, dadurch gekennzeichnet, daß die Zusatzschicht eine Sperrschicht darstellt.

9. Verfahren nach einem der Patentansprüche 7 oder 8 in Verbindung mit Patentanspruch 2, dadurch gekennzeichnet, daß für die Bildung der Drain- und Source-Zonen eine zusätzliche Zugabe von Dotierungsmitteln zwischen Schritt a3) und a4) stattfindet.

10. Verfahren nach einem der vorhergehenden Patentansprüche, dadurch gekennzeichnet, daß für die erste Schicht und die Oberflächenschicht gleiche Werkstoffe benutzt werden.

11. Feldeffekttransistor mit isolierter Steuerelektrode, mit einem Steuerelektrodenbereich, dessen halbleitender oder leitender Mittelteil (213) auf einem halbleitenden oder leitenden unteren Teil (214) angeordnet ist, der vom Substrat durch eine Sperrschicht (202) getrennt ist, sowie mit seitlichen Sperrbereichen (215, 216), die auf dem Mittelteil und der Oberseite des unteren Teils aufliegen, dadurch gekennzeichnet, daß der untere Teil (214) des Steuerelektrodenbereichs zum Mittelteil (213) zwei unsymmetrische seitliche Schenkel bildet.

12. Transistor nach Patentanspruch 11, dadurch gekennzeichnet, daß die Drain-Zone (234) und die Source-Zone (235) unterschiedlich stark dotiert sind.

13. Transistor nach Patentanspruch 11 oder 12, dadurch gekennzeichnet, daß die seitlichen Schenkel des unteren Steuerelektrodenbereichs (214) teilweise die Drain-Zone (234) bzw. die Source-Zone (235) überdecken.

14. Transistor nach Patentansprüchen 12 und 13, dadurch gekennzeichnet, daß die Drain-Zone schwächer als die Source-Zone dotiert ist und teilweise vom längeren Schenkel des unteren Steuerelektrodenbereichs (214) überdeckt ist.

## Claims

1. Method of fabricating an insulated gate field effect transistor including in a predetermined area of a semiconductor substrate (201, 301) the formation of semiconductor source and drain regions and the formation between these two regions of an insulated gate region, the formation of the gate region including the following steps:
a) forming on the upper surface of a first semiconductor or conductor layer (203, 303) disposed on a primary insulator layer (202, 302) covering said predetermined area of substrate (201, 301) a stepped structure comprising a semiconductor or conductor surface layer (10) having a chosen thickness (e) and constituting a step, and forming, at the location of said step, by anisotropic etching of said surface layer, a projecting region (212; 312) including on the one hand, a central part (211; 311) formed by the residual unetched part of the surface layer, the width (L) of which at the foot, which is related to the thickness (e) of the surface layer (10), defines the length of the channel of the transistor, and on the other hand, asymmetric insulator lateral regions (233, 334) delimiting said central part,
b) anisotropic etching of the block formed in step a) so as to partially etch the projecting region and to etch, to its full thickness, the part of the first semiconductor or conductor layer (203, 303) on either side of said projecting region,
the semiconductor or conductor gate region on the other hand, comprising a central region formed by the residual unetched area of the central part of the projecting region and by the residual unetched area (214, 314) of the first semiconductor or conductor layer defining two asymmetric lateral branches relative to said central region, and on the other hand, being insulated from the substrate by the part of the primary insulator layer situated under said residual unetched area (214, 314) of the first semiconductor or conductor layer (203, 303).

2. Method according to claim 1 characterised in that the formation of the semiconductor drain and source regions includes a first implantation of dopants effected after the formation of the central part of the projecting region and before the formation of the insulator lateral regions, and a second implantation of dopants effected after step b).

3. Method according to claim 1 or 2 characterised in that the width at the foot of the central part of the projecting region is in the order of 10² nm (1 000 Å).

4. Method according to any one of claims 1 to 3 characterised in that in step a):
a1) an additional layer (5) having a chosen thickness is deposited on the upper face of said first layer (203, 303) and a predetermined area of said additional layer is etched, to its full thickness, to form a flank (8) for the residual unetched area (6) of this additional layer (5) and to uncover the corresponding part (7) of the upper face of said first layer,
a2) a conformal deposition of the surface layer (10) having a thickness chosen to form said stepped structure is effected on the block formed in step al),
a3) said surface layer (10) is etched anisotropically to its full thickness so as to leave only a residual surface layer area (211, 311) resting on said flank (8), and
a4) the residual additional layer area (6) is etched selectively, to its full thickness, to leave on said first layer only a part at least of the residual unetched area of the surface layer to form the central part of the projecting region.

5. Method according to claim 4 characterised in that the formation of the asymmetric insulator lateral regions (233, 234) delimiting the central part (211) of the projecting region includes the deposition of an insulator layer on the block formed in step a4) followed by anistropic etching of said insulator layer.

6. Method according to claim 4 or 5 characterised in that said predetermined substrate area (201, 301) is delimited by an electrical insulator area (204,304) and in that in step al) the partial etching of the additional layer forms another flank for the residual unetched area (6) of said additional layer, said other flank being situated in said insulator area (204, 304).

7. Method according to claim 4, 5 or 6 characterised in that the height of the part of the residual area of the surface layer remaining after step a4) is greater than the thickness of the first semiconductor or conductor layer (203, 303), and in that the part of the residual area of the surface layer remaining after step a4) forms said central part of the projecting region.

8. Method according to any one of claims 4 to 7 characterised in that the additional layer is an insulator layer.

9. Method according to claim 7 or 8 in conjunction with claim 2 characterised in that the formation of the drain and source regions includes an additional implantation of dopants effected between step a3) and step a4).

10. Method according to any one of the preceding claims characterised in that the same material is chosen for the first layer and the surface layer.

11. Insulated gate field effect transistor comprising a gate region including a semiconductor or conductor central part (213) disposed on a semiconductor or conductor lower part (214) insulated from the substrate by an insulator layer (202) and insulator lateral regions (215, 216) resting on the central part and on the upper face of the lower part, characterised in that the lower part (214) of the gate region defines two asymmetric lateral branches relative to the central part (213).

12. Transistor according to claim 11 characterised in that one of the drain (234) and source (235) regions is more strongly doped than the other.

13. Transistor according to claim 11 or 12 characterised in that the lateral branches of the lower gate part (214) partly cover the drain (234) and source (235) regions, respectively.

14. Transistor according to claims 12 and 13 characterised in that the drain region, more weakly doped than the source region, is partly covered by the longer branch of the lower gate part (214).
